Europäisches Patentamt

European Patent Office

Office européen des brevets

(11) Numéro de publication : **0 618 657 B1**

(12) **FASCICULE DE BREVET EUROPEEN**

(45) Date de publication du fascicule du brevet :
27.09.95 Bulletin 95/39

(51) Int. Cl.⁶ : **H02H 3/20**, G01R 19/165

(21) Numéro de dépôt : 94400736.8

(22) Date de dépôt : **05.04.94**

(54) **Circuit de déclenchement automatique.**

(30) Priorité : **02.04.93 FR 9303934**

(43) Date de publication de la demande :
**05.10.94 Bulletin 94/40**

(45) Mention de la délivrance du brevet :
**27.09.95 Bulletin 95/39**

(84) Etats contractants désignés :
**DE ES GB IT NL**

(56) Documents cités :
**DE-A- 3 119 923**

(73) Titulaire : **GEMPLUS CARD INTERNATIONAL**
**Avenue du Pic de Bertagne,**
**Parc d'activités de la Plaine de Jouques**
**F-13420 Gemenos (FR)**

(72) Inventeur : **Kowalski, Jacek Antoni, Cabinet**
**BALLOT-SCHMIT**
**7 rue Le Sueur**
**F-75116 Paris (FR)**

(74) Mandataire : **Schmit, Christian Norbert Marie**
**Cabinet Ballot-Schmit**
**7, rue Le Sueur**
**F-75116 Paris (FR)**

EP 0 618 657 B1

**Description**

La présente invention a pour objet un circuit de déclenchement automatique, notamment un circuit de remise à zéro, utilisable dans tout circuit électronique. L'invention est destinée a être utilisée plus particulièrement dans le domaine des cartes à puces. Elle peut être utilisée cependant dans tous les domaines où des standards d'alimentation électrique sont destinés à évoluer du fait de perfectionnements technologiques des circuits électroniques.

La plupart des circuit intégrés actuels fonctionnement avec une tension d'alimentation voisine de 5 Volts à plus ou moins 10%. Ceci est également vrai pour les circuits pour les cartes à puces. Cependant, dans tous les domaines, il y a actuellement un nette tendance à diminuer cette tension d'alimentation, par exemple jusqu'à 3 Volts ou même plus bas. Il est notamment prévu que tous les circuits utilisables dans les micro-ordinateurs portables devront fonctionner à 3,3 Volts. En ce qui concerne le domaine des cartes à puces, les circuits doivent pouvoir fonctionner tant à 5 Volts qu'à 3 Volts ou même à une tension plus basse. Ceci est dû au fait que les cartes à puces doivent pouvoir être utilisées aussi bien par des équipements alimentés en 5 Volts que par des équipements alimentés en 3 Volts.

Pour tous les circuits électronique, notamment pour les circuits utilisés dans les cartes à puces, une notion de sécurité doit être considérée. En effet, une carte à puce doit fonctionner correctement non seulement dans une gamme de tension d'alimentation spécifiée, mais également en dehors de cette gamme pour empêcher, par exemple, un éventuel fraudeur de profiter d'un disfonctionnement hors de cette gamme pour découvrir les secrets de la carte et/ou de modifier son contenu mémorisé, par exemple ajouter des unités monétaires. Pour se protéger de ces tentatives, la plupart des circuits intégrés sont équipés de circuits de déclenchement qui bloquent le fonctionnement de la carte en dehors d'une certaine gamme de tension.

Par exemple pour un circuit fonctionnant sous 5 Volts la tension de déclenchement basse se situe autour de 3,5 Volts et la tension haute autour de 6,5 Volts. Ces marges importantes, supérieures à plus ou moins 10%, sont respectées pour deux raisons:

- ces seuils de déclenchement dépendent des paramètres de fabrication du circuit intégré, donc ils varient suivant le lot de production;
- ces seuils dépendent souvent fortement de la température. Ainsi pour respecter la spécification d'un fonctionnement à 5 Volts +/- 10% une marge importante doit être utilisée.

Le problème se pose encore plus crûment quand on veut descendre en tension. Par exemple, pour avoir une circuit électronique fonctionnel entre 2,5 Volts et 6 Volts, il faudrait choisir des seuils de déclenchement égaux à environ 2 Volts et 7 Volts. Mais avec la température et les changements des paramètres de fabrication, ces seuils peuvent varier d'euxmême entre 1,5 et 2,5 Volts et entre 6 et 8 Volts.

Pour les tensions élevées, le problème est moins important, car, en général, un circuit intégré électronique, une puce, fonctionne correctement aussi bien à 6 Volts qu'à 8 Volts. Par contre pour les tensions basses, les circuits ne fonctionnent pas correctement à 1,5 Volts et il est alors possible de frauder en utilisant certains composants, et en profitant de leur disfonctionnement à basse tension. Ce problème rend très difficile la conception d'un circuit pour carte à puce fiable et non fraudable pour des tensions d'alimentation inférieures à 3 Volts.

Le but de l'invention est donc d'arriver à construire un circuit de déclenchement stable en tension de seuil, et ajustable, par exemple au début de la vie du composant électronique, notamment lors d'un test de ce composant. Ceci permettrait d'éliminer d'une part la dépendance de la tension de déclenchement aux paramètres du lot de fabrication, à la température, à la tension d'alimentation, et d'autre part d'avoir une valeur de tension de déclenchement réglable.

L'invention remédie aux inconvénients cités en proposant l'utilisation d'un amplificateur différentiel dont au moins une des branches est montée en cascade avec une cellule comportant un transistor à grille flottante programmable et effaçable électriquement, du type EEPROM. L'idée consiste à stocker dans la grille flottante du transistor d'une telle cellule EEPROM des charges électriques correspondant à une tension de référence qui sera utilisée pour déterminer le seuil de déclenchement du circuit. Ainsi cette tension peut facilement être comprise entre 0 et 5 Volts avec une grande précision. Comme le seuil de déclenchement est ajusté lors d'un test du circuit à la fabrication on s'affranchit entièrement d'une dépendance de paramètres de procédé de fabrication. L'indépendance du seuil vis à vis des lots de fabrication, température, et tension d'alimentation est obtenue par le circuit différentiel. Dans l'autre branche de ce circuit on monte une autre cellule du même type. En pratique on compare la différence des seuils de déclenchement à une tension à surveiller.

L'invention a donc pour objet un circuit de déclenchement automatique, notamment de remise à zéro, comportant un comparateur de tension recevant un premier niveau de tension et un deuxième niveau de tension, et produisant une variation d'un signal de sortie lorsqu'une différence de tension à surveiller franchit un seuil, caractérisé en ce qu'il comporte

- un miroir de courant à deux branches, ce miroir étant branché entre une alimentation électrique continue et une masse, chaque branche comportant un transistor de réglage du courant, ces deux transistors étant montés ensemble en miroir,

- dans chacune des branches, en aval des transistors de réglage, un transistor de détection, un au moins de ces transistors de détection étant un transistor à grille flottante,

les deux branches étant réunies en aval des deux transistors de détection à un transistor de couplage à la masse.

L'invention sera mieux comprise à la lecture de la description qui suit et à l'examen des figures qui l'accompagnent, celles-ci ne sont données qu'à titre indicatif et nullement limitatif de l'invention.

Les figures montrent:
- Figure 1: une représentation schématique d'un circuit de déclenchement conforme à l'invention;
- Figures 2a à 3d: des diagrammes temporels de signaux électriques utilisés pour programmer le circuit de l'invention, et variant en fonction du temps.

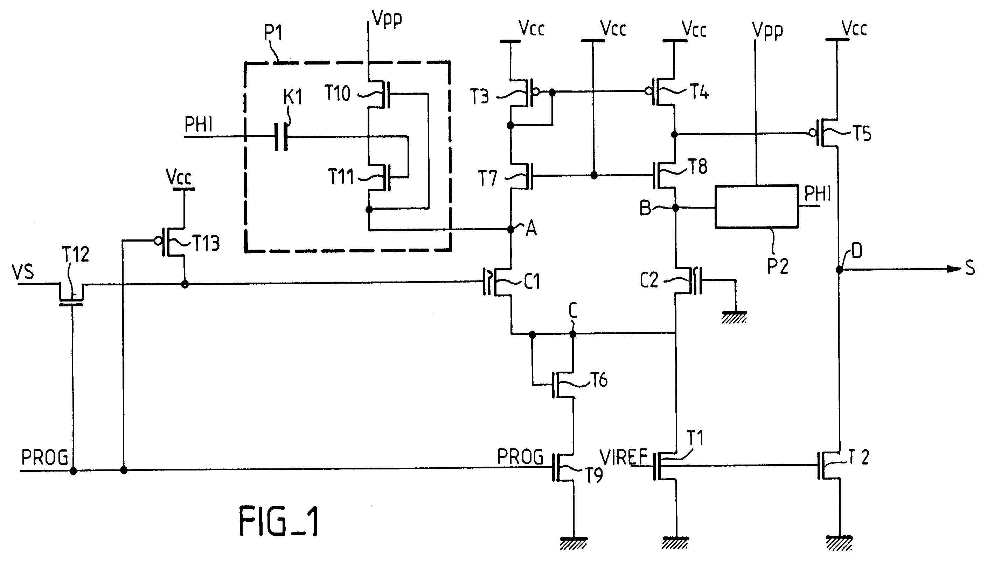

La figure 1 montre un circuit de déclenchement automatique conforme à l'invention. Ce circuit comporte un comparateur amplificateur différentiel constitué ici sous la forme d'un miroir de courant à deux branches. Ce miroir comporte dans chacune des branches un transistor, respectivement T3 et T4. Ces transistors T3 et T4, de type P dans l'exemple, ont leur source reliée à une alimentation Vcc et leur drain connecté, plus loin en aval, à la masse. Ces transistors T3 et T4 sont des transistors de réglage du courant dans chaque branche. Ils sont montés en miroir. En pratique la grille du transistor T3 est connectée au drain du transistor T3 et à la grille du transistor T4. Dans chacune des branches, en aval des transistors de réglage T3 et T4, on a connecté des transistors de détection, respectivement C1 et C2. Au moins un de ces transistors de détection, le transistor C1, est un transistor à grille flottante. Les transistors C1 et C2 sont de type N, ont leurs drains raccordés aux drains des transistors T3 et T4, en des noeuds A et B respectivement, et leurs sources raccordées, ensemble, à un noeud C, au drain d'un transistor T1 de type N de couplage à la masse. La grille du transistor de détection C1 est reliée à un niveau de tension à surveiller: par exemple la tension Vcc. La grille du transistor C2 est reliée à une autre tension de référence: par exemple la masse. La tension surveillée est la différence de tension entre ces deux tensions.

Les transistors C1 et C2 sont du type EEPROM, programmables et effaçables électriquement. Ils ont des seuils de conduction différents. Le seuil de conduction du transistor C1 vaut par exemple une tension Vs-Vt. Le seuil de conduction du transistor C2 vaut -Vt. Le détecteur ainsi conçu bascule à chaque fois que la différence de tension à surveiller (ici Vcc par rapport à la masse) franchit un niveau de tension de référence égal à la différence des seuils de détection des deux transistors C1 et C2: c'est à dire Vs. Vt est un seuil de conduction d'un transistor normal enrichi; Vt vaut de 0,5 à 1 Volt selon la technologie d'implantation retenue.

Le drain du transistor T4 est également relié à la grille d'un transistor T5 de type P lui aussi raccordé entre Vcc et la masse, en cascade avec un transistor T2 de type N. Le transistor T1 et le transistor T2 de type N reçoivent sur leur grille un potentiel dit VIRef, qui en pratique vaut environ 1 Volt, dont la valeur n'est pas sensible pour le fonctionnement du circuit, et qui permet par ailleurs de fixer un courant de référence faible dans le circuit pour limiter sa consommation. Au point milieu, noeud D, entre les drains des transistors T5 et T2 on prélève un signal S de sortie qui bascule quand la tension à surveiller franchit le seuil Vs.

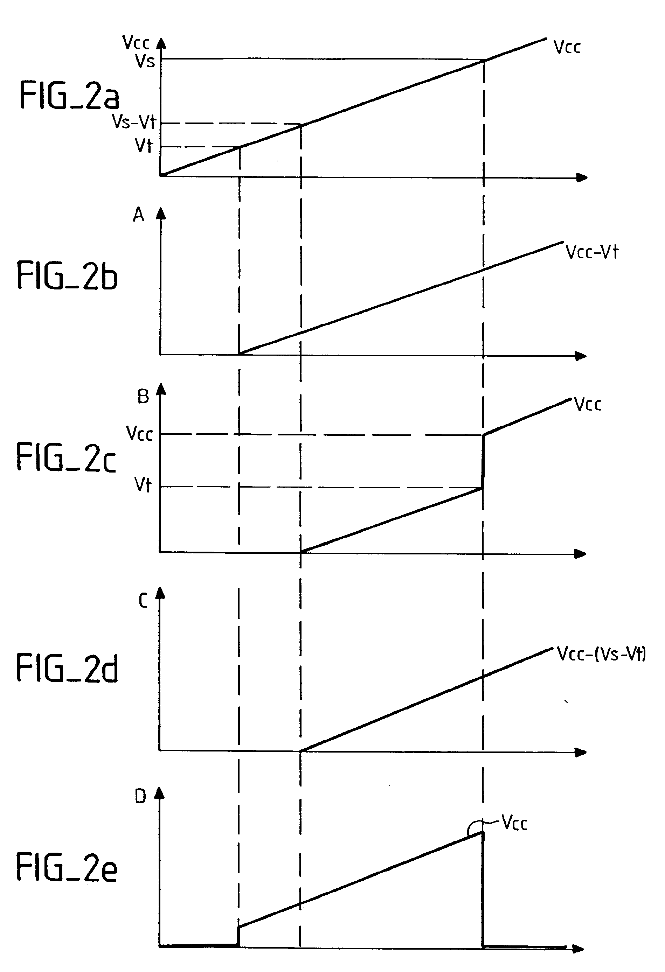

Le fonctionnement en détection du circuit est le suivant. Tant que la tension à surveiller, ici la tension d'alimentation Vcc qui alimente le miroir T3-T4, est inférieure à Vs, les transistors T3 et T4 sont bloqués. En effet, figures 2a à 2e, lorsque la tension Vcc, proche de 0 Volt, commence à monter, le transistor C2 est passant, à la limite de la conduction. En effet il possède un seuil de conduction négatif -Vt. Les transistors T3 et T4 de type P sont bloqués parce que la tension Vcc au début est encore inférieure à leur seuil de conduction de l'ordre de Vt également. Dans ces conditions le transistor C2 tire le potentiel du noeud B à zéro. Le potentiel au noeud B à zéro rend conducteur le transistor T5 dès que Vcc devient supérieur à Vt. Ce qui fait que le signal S au noeud D suit ensuite la variation de Vcc, figure 2e.

Tant que la tension Vcc, supérieure à Vt, reste inférieure à Vs - Vt, tout le courant du transistor T1, qui décharge le potentiel au noeud B passe par le transistor C2. Les transistors T3 et T4 restent bloqués, et le potentiel B est environ à O Volt car T4 est bloqué. Dans ces conditions, la sortie S au noeud D vaut Vcc car T5 conduit et que le courant passant dans T1 et T2 est très faible (environ 1 microampère), ces transistors T1 et T2 étant à la limite de conduction.

Lorsque la tension Vcc devient supérieure à Vs - Vt la tension au noeud C augmente. En effet, dans le miroir de courant, le transistor T3 impose le courant. Comme au début C1 était bloqué, le transistor T3 ne pouvait passer aucun courant, il était bloqué. Donc T4 était également bloqué puisque son fonctionnement était imposé par T3. Dans ces conditions la tension au noeud C était nulle, figure 2d.

Comme la tension, Vcc, appliquée sur la grille de commande de C1 monte à Vs - Vt, C1 va se mettre à conduire. Il se met à conduire dès que cette tension appliquée devient supérieure à celle de son seuil qui vaut Vs - Vt. Dès que C1 conduit, T3 et T4 se mettent à conduire. Cependant, le courant fourni par T3 juste à ce moment est faible car, d'une part, ce courant est limité par T1 (à la limite de conduction), et d'autre part le courant passant dans T1 est partagé entre le courant passant par C1 et le courant passant par C2.

Au début de cette mise en conduction de C1, la tension Vgs - Vseuil (Vgs est la tension grille source) de C1 est plus petite que la tension Vgs - Vseuil de C2. Ceci implique que C2 conduise plus que C1. Avec la continuation de l'augmentation de Vcc, cette situation s'inverse: C2 ne conduit plus et C1 conduit plus que C2. Pendant le début de conduction de C1, la tension Vgs - Vseuil de C1 va rester faible, ce qui implique que la tension au noeud C va alors commencer à monter avec Vcc, celle au noeud B également, figures 2c et 2d.

Au moment de l'inversion, lorsque Vcc vaut Vs, C2 se bloque, les tensions aux noeuds A et C continuent à monter. Celle au noeud B bascule parce que T4 conduit et parce que plus rien ne tire le potentiel de B vers zéro puisque C2 est bloqué. Le transistor C2 se bloque car bien que son seuil de conduction soit négatif, le tension au point C a tellement augmenté qu'elle devient supérieure en valeur absolue à cette valeur.

Si les seuils de conduction dans les transistors C1 et C2 ont été programmés correctement aux valeurs indiquées, la tension de sortie S passe à zéro dès que la tension de Vcc dépasse Vs. A ce moment en effet, le transistor C1 est soumis à un potentiel grille source supérieur au potentiel grille source du transistor C2. Ceci est dû à ce que le potentiel grille source de C2 devient plus faible que -Vt avec l'augmentation du potentiel du noeud C.

Ce circuit est indépendant de la température et des paramètres de fabrication. Ceci est dû au fait que les tensions de seuil changent de la même façon pour le transistors C1 que pour le transistor C2. On obtient une tension de détection égale à

$$(Vs - Vt + \alpha) - (- Vt + \alpha)$$

$\alpha$ représentant une dispersion identique due à la fabrication, la température, ou la tension.

La tension Vs est mémorisée dans le circuit lors des opérations de test du fonctionnement de ce circuit. Elle est mémorisée au cours d'une opération de programmation.

Pour programmer les deux transistors à grille flottante C1 et C2 on procède de préférence de la façon suivante. Les noeuds A et B sont connectés à des pompes de charge respectivement P1 et P2. La pompe P1 est détaillée sur la figure. Cette pompe P1 comporte une entrée d'alimentation pour un potentiel de programmation Vpp et une entrée d'horloge recevant un signal de phase PHI. La pompe P1 comporte deux transistors T10 et T11 de type N en cascade, le drain du transistor T10 étant connecté à une source de tension de programmation Vpp, la source de ce transistor T10 étant reliée au drain du transistor T11, la source du transistor T11 constituant la sortie de la pompe P1 et étant par ailleurs reliée à la grille du transistor T10. La grille du transistor T11 est reliée au point milieu entre les transistors T10 et T11. L'entrée de phase est connectée à ce point milieu par l'intermédiaire d'un condensateur K1. Pour éviter de court-circuiter les noeuds A et B à la tension Vcc lors de la programmation, on a interposé entre ces noeuds et les transistors T3 et T4 respectivement des transistors de découplage T7 et T8 de type N. Ces transistors T7 et T8 reçoivent sur leurs grille de commande la tension d'alimentation Vcc. Tant que les transistors T7 et T8 ont à transmettre un potentiel positif reçu des transistors T3 ou T4, il conduisent. Par contre, si les potentiels aux noeuds A et B deviennent plus grand que Vcc, ces transistors se bloquent puisque dans ce cas leurs grilles sont au même potentiel que leur source.

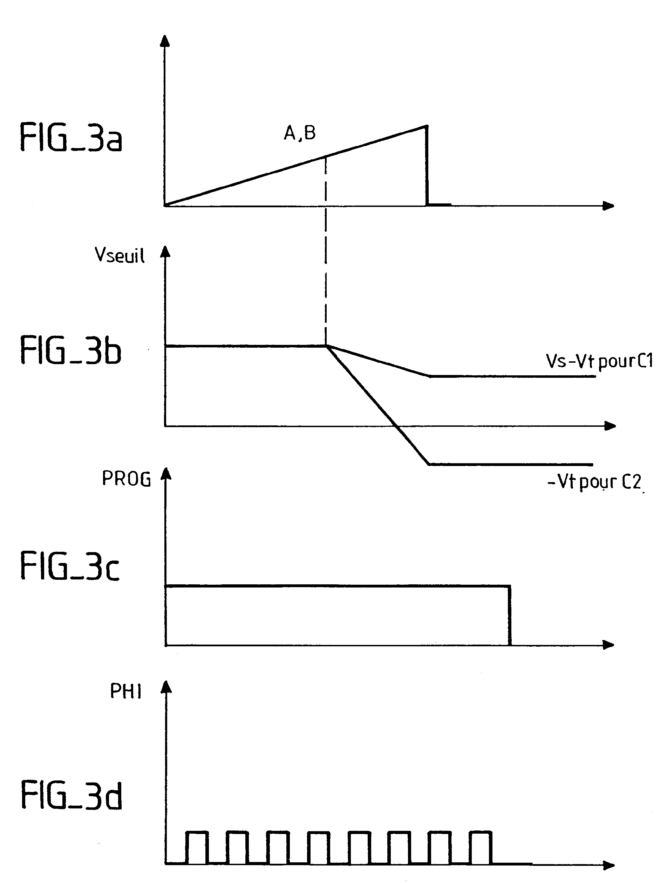

A chaque impulsion Figure 3d, envoyée sur le condensateur K1 par l'horloge, une petite quantité d'énergie est transmise au noeud A et au noeud B, Figure 3a. Au moment de la programmation, un signal PROG est appliqué sur les grilles de commande de transistors de sélection respectivement T12 de type N et T13 de type P. Une tension de seuil Vs est imposée sur une borne du circuit. Le transistor T12 est relié à cette borne. Le transistor T13 reçoit la tension à surveiller (Vcc) et la transmet sur la grille de C1. Le transistor T12 transmet, lorsqu'il reçoit un signal PROG positif sur sa grille, la valeur de tension de seuil Vs sur la grille de commande du transistor à grille flottante C1. Dans les même conditions de programmation, le transistor T13 se bloque. Par contre, hors période de programmation, le transistor T12 est bloqué, le transistor T13 est en court circuit: le transistor C1 surveille la tension qui lui est appliquée et transmise par le transistor T13 : ici en l'occurrence la tension Vcc.

Au moment de la programmation on met en service, au moyen de transistors de type N T6 et T9 montés en cascade, une dérivation à la masse du noeud C. Le transistor T6 se comporte comme une diode: de préférence sa grille est connectée à son drain. Le transistor T9 reçoit le signal PROG sur sa grille de commande. Les pompes de charge P1 et P2 permettent d'appliquer la tension Vpp sur les noeuds A et B lors de la programmation du dispositif. Dès que PHI commence à osciller, une tension de sortie de ces pompes de charges s'élève à Vpp plus Vt. L'avantage de ces pompes vient du fait que, même si un des noeuds A ou B devait voir son potentiel s'écrouler, il n'y aurait pas une trop grosse consommation de courant puisque seule l'énergie du signal PHI est consommée.

Au début de la programmation, chargés lentement par les pompes de charge P1 et P2, les potentiels des noeuds A et B montent, figure 3a. Chacun des transistors C1 ou C2 est normalement dans un état effacé, par exemple avec une tension de seuil égale à 6 Volts. Ils commencent alors à se programmer, par exemple d'abord le transistor C2. La tension de seuil, figure 3b, de ce transistor C2 commence à se modifier du fait de l'injection de charges, en pratique des trous, dans sa grille flottante. Lorsque la tension de seuil du transistor concerné, le transistor C2, atteint le seuil requis (c'est à dire que ces trous, par le champ électrique qu'ils imposent, provoquent la mise en conduction du canal de conduction), ce transistor commence à conduire et la programmation s'arrête. Pour C2 le seuil requis est -Vt. Ce seuil requis est obtenu par connexion de la grille de commande de C2 à la masse. Au moment de la mise en conduction la tension de seuil du transistor devient alors inférieure à sa tension grille source Vseuil < Vgs. Dans le cas de C2, cette tension grille source vaut -Vt parce que T6 monté en diode impose que le potentiel du noeud C vaille Vt, donc Vgs au départ vaut -Vt.

Comme la pompe de charge concernée, la pompe P2, ne supporte aucun courant de fuite du fait des petites quantités d'énergie transmise par chaque impulsion du signal PHI, la tension sur le noeud concerné, le noeud B, baisse du fait de la conduction et la programmation s'arrête. Il en est de même pour le noeud A et la programmation à Vs-Vt du seuil du transistor C1.

Ainsi le système s'autoprogramme, il suffit d'appliquer la tension de référence Vs sur la grille de C1. Dans certains cas, il faut effacer les deux transistors C1 et C2 avant la programmation. En effet, quelques fois, à la sortie de fabrication, des cellules de type EEPROM on des tensions de seuils inférieures à -Vt (elles peuvent même atteindre -4 Volts).

Dans un fonctionnement plus simple, le dispositif peut être remplacé par un autre, un peu moins précis. Dans ce cas le transistor C2 peut être remplacé par un transistor natif: un transistor normal, pas à grille flottante, et dont le seuil de conduction de l'ordre de 0 Volt est ajusté au moment des étapes de fabrication, par une suppression d'injection d'impuretés dans son canal de conduction. Dans un tel dispositif, il n'y aurait qu'une seule cellule EEPROM de détection. Ce dispositif se déclenche alors à Vcc = Vs. Cependant ce dispositif est moins précis car les tensions de seuil des deux transistors C1 et C2 ne changent alors pas de la même façon en fonction de la température. Avec un dispositif ainsi simplifié une variation de l'ordre de 0,2 à 0,3 Volts peut être observée en tolérance de la valeur de la tension de déclenchement en fonction de la température.

Le dispositif décrit ci-dessus permet de résoudre les problèmes relatifs au choix des tensions de déclenchement internes à un circuit. De plus ce circuit est indépendant des paramètres du procédé de fabrication ainsi que de la température. La solution proposée permet de satisfaire le besoin de tous les types de circuits, notamment pour les cartes à puces. Il a par ailleurs l'avantage d'avoir une consommation très basse, inférieure à 1 microampère, et donc s'applique également à tous les circuits basse consommation.

La stabilité du dispositif dépend de la faculté de rétention des charges sur les grilles flottantes des transistors C1 et ou C2. En effet les charges stockées sur une grille flottante d'une cellule EEPROM peuvent fuir légèrement. Des mesures ont été effectuées sur des cellules existantes. Il résulte de ces mesures que le changement de la tension de seuil d'une cellule EEPROM est de l'ordre de 0,2 Volts en 10 ans. C'est donc la marge qu'il faut prendre par rapport à la tension de déclenchement désirée au moment de la programmation du dispositif.

Le signal S est ensuite exploité dans le circuit par exemple pour neutraliser son fonctionnement.

## Revendications

1. Circuit de déclenchement automatique, notamment de remise à zéro, comportant un comparateur de tension recevant un premier niveau de tension (Vcc) et un deuxième niveau de tension, et produisant une variation d'un signal de sortie (D) lorsqu'une différence de tension à surveiller franchit un seuil (VS), caractérisé en ce qu'il comporte

   - un miroir de courant à deux branches (T3,T4), ce miroir étant branché entre une alimentation électrique continue et une masse, chaque branche comportant un transistor (T3, T4) de réglage du courant ces deux transistors étant montés ensemble en miroir,
   - dans chacune des branches, en aval des transistors de réglage, un transistor (C1,C2) de détection, un au moins de ces transistors de détection étant un transistor à grille flottante,
   - les deux branches étant réunies en aval des deux transistors de détection à un transistor (T1) de couplage à la masse.

2. Circuit selon la revendication 1, caractérisé en ce que dans une branche, entre le transistor de réglage et le transistor de détection à grille flottante, on intercale un transistor (T7, T8) de découplage pour permettre la programmation du transistor de détection à grille flottante.

3. Circuit selon la revendication 1 ou la revendication 2, caractérisé en ce qu'un transistor de détection à grille flottante est prévu dans chaque branche, la différence des seuils de conduction entre les deux transistors à grille flottante (C1,C2) étant égale au seuil de la différence de tension à surveiller pour constituer un circuit de déclenchement indépendant de la température ou de la valeur d'une tension d'alimentation.

4. Circuit selon l'une des revendications 1 à 3, caractérisé en ce qu'il comporte une pompe de charge (P1,P2) à débit de courant limité pour programmer chaque transistor de détection à grille flottante (C1, C2).

5. Circuit selon l'une des revendications 1 à 4, caractérisé en ce que le ou les transistors à grille flottante (C1, C2) sont du type EEPROM.

6. Circuit selon l'une des revendications 1 à 5, caractérisé en ce qu'il comporte un circuit (T12, T13, P1, P2) de programmation du ou des transistors à grille flottante (C1, C2) muni:
   - de pompe de charge (P1, P2) pour appliquer une tension de programmation,
   - d'un premier circuit (T6) pour appliquer un premier potentiel de référence (Vt) sur un des transistors à grille flottante,
   - d'un deuxième circuit (T13) pour appliquer un deuxième potentiel de référence sur un autre transistor à grille flottante, et
   - d'un troisième circuit (T9, T12) pour provoquer la programmation simultanée des deux transistors à grille flottante.

## Patentansprüche

1. Automatische Triggerschaltung, insbesondere eine Nullungsschaltung, mit einem Spannungs-Komparator, der einen ersten Spannungspegel (Vcc) und einen zweiten Spannungspegel empfängt und für eine Änderung eines Ausgangssignals (D) sorgt, wenn eine zu überwachende Spannungsdifferenz einen Schwellenwert (VS) überschreitet, dadurch gekennzeichnet, daß sie umfaßt:
   - einen Stromspiegel (T3, T4) mit zwei Zweigen, wobei dieser Spiegel zwischen einer Gleichstromzuführung und einer Masse geschaltet ist und jeder Zweig einen Transistor (T3, T4) zur Stromregelung umfaßt und diese beiden Transistoren zusammen als Spiegel montiert sind,
   - in jedem Zweig, den Regeltransistoren nachgeschaltet, einen Erfassungstransistor (C1, C2), wobei mindestens einer dieser Erfassungstransistoren ein Transistor mit offenem Gitter ist,
   - wobei die beiden Zweige, den beiden Erfassungstransistoren nachgeschaltet, mit einem Massekopplungstransistor (T1) verbunden sind.

2. Schaltung nach Anspruch 1, dadurch gekennzeichnet, daß man bei einem Zweig zwischen dem Regeltransistor und dem Erfassungstransistor mit offenem Gitter einen Entkopplungstransistor (T7, T8) zwischenschaltet, um die Programmierung des Erfassungstransistors mit offenem Gitter zu ermöglichen.

3. Schaltung nach Anspruch 1 oder 2, dadurch gekennzeichnet, daß in jedem Zweig ein Erfassungstransistor mit offenem Gitter vorgesehen ist, wobei die Differenz der Leitungsschwellenwerte zwischen den beiden Transistoren mit offenem Gitter (C1, C2) gleich dem Schwellenwert der zu überwachenden Spannungsdifferenz ist, um eine von der Temperatur oder dem Wert einer Speisespannung unabhängige Triggerschaltung zu bilden.

4. Schaltung nach einem der Ansprüche 1 bis 3, dadurch gekennzeichnet, daß sie eine Ladungspumpe (P1, P2) mit begrenztem Stromfluß zur Programmierung jedes Erfassungstransistors mit offenem Gitter (C1, C2) aufweist.

5. Schaltung nach einem der Ansprüche 1 bis 4, dadurch gekennzeichnet, daß der oder die Transistor/en mit offenem Gitter (C1, C2) vom Typ EEPROM sind.

6. Schaltung nach einem der Ansprüche 1 bis 5, dadurch gekennzeichnet, daß sie eine Schaltung (T12, T13, P1, P2) zur Programmierung des Transistors bzw. der Transistoren mit offenem Gitter (C1, C2) aufweist, die umfaßt:
   - eine Ladungspumpe (P1, P2) zum Anlegen einer Programmierungsspannung,
   - eine erste Schaltung (T6) zum Anlegen eines ersten Bezugspotentials (Vt) an einen der Transistoren mit offenem Gitter,
   - eine zweite Schaltung (T13) zum Anlegen eines zweiten Bezugspotentials an einen anderen Transistor mit offenem Gitter, und
   - eine dritte Schaltung (T9, T12) zur gleichzeitigen Programmierung der beiden Transistoren mit offenem Gitter.

## Claims

1. Automatic triggering circuit, particularly for rezeroing, comprising a voltage comparator receiving a first voltage level (Vcc) and producing a variation of an output signal (D) when a voltage difference to be monitored exceeds a certain threshold (VS), characterized by the fact that it comprises:
   - a current mirror with two branches (T3, T4), this mirror being connected between a continuous electrical supply and a mass, each branch comprising a current regulating transistor (T3, T4), these two transistors being mounted together mirror-wise,
- in each of the branches, below the regulating transistors, a detection transistor (C1, C2), at least one of these detection transistors being a floating-grid transistor,
- the two branches being connected, below the two detection transistors, to an earth connection transistor (T1).

2. Circuit according to Claim 1, characterized in that in one branch, between the regulating transistor and the floating-grid detection transistor, a disconnection transistor (T7, T8) is interposed, to enable the floating-grid detection transistor to be programmed.

3. Circuit according to Claim 1 or Claim 2, characterized in that a floating-grid detection transistor is provided in each branch, the difference between the conduction thresholds between the two floating-grid transistors (C1, C2) being equal to the threshold of the voltage difference to be monitored, in order to form a disconnection circuit independent of the temperature or of the value of a supply voltage.

4. Circuit according to any one of Claims 1 to 3, characterized in that it comprises a charging pump (P1, P2) with limited current flow to program each floating-grid detection transistor (C1, C2).

5. Circuit according to any one of Claims 1 to 4, characterized in that the floating-grid transistor or transistors (C1, C2) is of the EEPROM type.

6. Circuit according to any one of Claims 1 to 5, characterized in that it comprises a programming circuit (T12, T13, P1, P2) of the floating-grid transistor or transistors (C1, C2), provided:
- with a charging pump (P1, P2) for the application of a programming voltage;
- with a first circuit (T6) for the application of a first reference potential (Vt) to one of the floating-grid transistors;
- with a second circuit (T13) for the application of a second reference potential to another floating-grid transistor, and
- with a third circuit (T9, T12) serving to set up the simultaneous programming of the two floating-grid transistors.

FIG_1

EP 0 618 657 B1

FIG_2a

Vcc
Vs
Vs-Vt
Vt

Vcc

FIG_2b

A

Vcc-Vt

FIG_2c

B

Vcc
Vt

Vcc

FIG_2d

C

Vcc-(Vs-Vt)

FIG_2e

D

Vcc

FIG_3a

FIG_3b

Vseuil

A,B

Vs-Vt pourC1

-Vt pour C2

PROG

FIG_3c

PHI

FIG_3d